# EUROPEAN PATENT APPLICATION

(11) **EP 0 609 047 A2**
(43) Date of publication of application: **03.08.1994**
(21) Application number: 94300533.0
(22) Date of filing: 25.01.1994
(51) Int. Cl.: H01L 21/82, H01L 27/02

(54) **Process for fabricating an ASIC device having a gate-array function block**

(30) Priority: 26.01.1993 JP 10809/93
(71) Applicant: HITACHI, LTD., Chiyoda-ku, Tokyo 101 (JP)
(72) Inventor: Fukuda, Hideki, Chofu-shi (JP); Hagiwara, Yoshimune, Hachioji-shi (JP); Ito, Satoru, Nakano-ku, Tokyo (JP); Torii, Shuichi, Higashiyamato-shi (JP); Kozawa, Tokinori, Nishitama-gun, Tokyo (JP); Yamashiro, Osamu, Tokorozawa-shi (JP)
(74) Representative: Calderbank, Thomas Roger

(57) **Abstract**

An IC device to be newly developed has at least one first function block (11A-11C, 12A, 12B, 14) and at least one second function block (13A, 13B) in which the first and second function blocks of the to-be-newly developed IC device is formed in a single semiconductor substrate, and logic design data of the first function block is available and that of the second function block needs to be newly prepared at a start of fabrication of the IC device. The IC device is, in one embodiment of the present invention, fabricated by starting logic design (53) of the second function block to prepare logic design data of the second function block while doped layers are formed (55) in a semiconductor substrate for the first and second function blocks to provide a semi-completed IC chip, performing (57) mask design of wiring conductor pattern using the logic design data of the first function block and later obtained logic design data of said second function block to prepare mask design data for the IC device, and forming (57) conductor pattern using the mask design data on the semi-completed IC chip to complete a newly developed IC device.

## Description

The present invention relates to techniques for designing semiconductor integrated circuits and more particularly to an especially effective technique applied to design of an application specific integrated circuit (ASIC), and more particularly to an effective technique applied to design of a semiconductor integrated circuit including a combination of a standardized function block (module) which a maker possesses, a function block (standard cell) which a user has already developed and possessed, and a function block (gate array logic) which the user has newly developed.

Recently, semiconductor integrated circuits called an ASIC have been used widely compared to general-purpose large-scaled integrated circuits. Conventionally, in order to develop an ASIC, a gate array system or a standard cell system which reduces its turn-around time has been used.

The gate array system is a system for realizing a semiconductor integrated circuit which has desired logi functions by forming wiring conductors for connecting many logic gates disposed regularly on a semiconductor chip. The standard cell system is a system for realizing an LSI device by using standard cells (which may include a mega cell called a CPU core) entered beforehand in a library.

A designing technique for development of an ASIC using the gate array system among the above-mentioned designing systems is generally as follows. First, a user designs a logic circuit having a desired logic function, using a cell library tool, etc., provided by a maker and delivers data on the logic design to the maker. The maker manufactures semiconductor chips on which a diffusion layer pattern for regularly arranged logic gates, i.e., gate array chips where no wiring conductors are formed, and waits for further information from the user. When the maker receives logic design data from the user, the maker designs a wiring conductor pattern on the basis of the data, and completes evaluation LSI chips by forming wiring conductors on the gate array chip, and delivers some chips to the user. The user then incorporates the LSI chip received from the maker into a user's application system to evaluate the developed LSI device.

Japanese publication JP-A-2-192165 (laid-open July 27, 1990) discloses a semiconductor integrated circuit chip which includes a standard cell array and a gate array.

In the conventional design technique, however, when a defect is found by a test in the evaluation, the logic design and the wiring conductor pattern must be modified or changed, and a corresponding LSI device must then be made newly. Thus, the turn-around time (TAT) is increased undesirably.

The number of large scaled ASICs to be developed will be increased which has a combination of standardized function blocks (hereinafter, referred to as a "function module") which the maker possesses, function blocks includes standard cells which the user have already developed and possessed and function blocks including a gate array which the user newly develops.

Unless the user's logic design of a new function block which the user needs in the development of such ASIC is completed, the final logical function of the whole LSI device cannot be determined. Thus, an evaluation LSI chip is made in a process which includes the formation of a diffusion layers after the receipt of the final logic design data from the user. Thus, the inventors have clarified the fact that such large-scale ASIC development may suffer problems such that its turnaround time is long compared to the development of an LSI device composed, for example, of an gate array alone.

The "function block" referred to in this specification is intended to mean a circuit block having a function of processing a signal or signals inputted thereto and includes a plurality of elemental circuit blocks (e.g., standard cells) capable of performing basic logic functions such as an AND operation, an OR operation or the like. By specifically connecting the elemental circuit blocks with wiring conductors, the resulting function block may provide an arithmetic operation circuit capable of addition or multiplication of multi-bit inputs, a sequence circuit capable of generating a predetermined operation control signal responsive to a command code, a circuit capable of generating a series of predetermined signals responsive to an external trigger signal, and so forth.

The "function module" referred to in this specification means a circuit block realized with a plurality of standard cells capable of perforiming basic logic functions.

One preferred aim of the present invention is to provide a process of fabricating an IC device to be newly developed having at least one first function block and at least one second function block, the first and second function blocks of the to-be-newly developed IC device being formed in a single semiconductor substrate, wherein logic design data of the first function block is available and that of the second function block needs to be newly prepared at a start of fabrication of the IC device.

Another aim of the present invention is to provide an IC device which is developed in a short turnaround time.

It is a preferred aim of the present invention to provide a designing process for developing in a short time a large-scaled ASIC which has a combination of a standardized function block (function module) which a maker possesses or a function block including a standard cell which a user has already developed and possessed, or both those function blocks, and a function block including a gate array which the user newly develops.

It is a further preferred aim of the present invention to provide an evaluation semiconductor integrated circuit suitable for developing in a short time a large-scaled ASIC which has a combination of a standardized function block (function module) which a maker possesses or a function block including a standard cell which the user has already developed and possessed, or both those function blocks, and a function block including a gate array which a user newly develops.

According to one aspect of the present invention, an IC device to be newly developed has at least one first function block and at least one second function block in which the first and second function blocks of the to-be-newly developed IC device is formed in a single semiconductor substrate, and logic design data of the first function block is available and that of the second function block needs to be newly prepared at a start of fabrication of the IC device. The IC device is fabricated by performing logic design of the second function block to prepare logic design data of the second function block while doped layers are formed in a semiconductor substrate for the first and second function blocks to provide a semi-completed IC chip, performing mask design of wiring conductor pattern using the logic design data of the first function block and later obtained logic design data of said second function block to prepare mask design data for the IC device, and forming conductor pattern using the mask design data on the semi-completed IC chip to complete an IC device.

According to another aspect of the present invention, when a semiconductor integrated circuit is designed having a combination of a standardized function block which a maker has developed and possessed and/or a function block which a user has already developed and possessed, and a function block which the user has newly developed, a semi-completed IC chip is prepared by use of logic design data of the standardized function block and/or logic design data of the function block which the user possesses, the semi-completed IC chip having a semiconductor substrate including therein diffusion layers for elements and a gate array necessary for realization of the functions of the above-mentioned function blocks. Then, a wiring conductor pattern for the function block including the gate array which the user has newly developed is designed on the basis of later obtained logic design data on that function block. The wiring conductor pattern data, the logic design data on the function block which the maker possesses and the logic design data on the function block which the user possesses are used to determine a wiring conductor pattern of the whole prepared semi-completed IC chip to thereby complete an IC device.

According to a still further aspect of the present invention, a semi-completed sample IC chip is prepared by use of logic design data of the standardized function block and/or the function block which the user possesses, the sample IC chip having a semiconductor substrate including therein (1) diffusion layers and wiring conductors for elements necessary for realization of the functions of the above-mentioned function blocks and (2) wiring conductors for connecting those function blocks and another function block as an external device which the user newly develops. Meanwhile, a FPGA chip is prepared for the function block which the user newly develops, the FPGA chip having a gate array formed in a separate semiconductor substrate, with which it is possible for the user to write or program a logic function of the newly developed function block. The prepared semi-completed sample IC chip and EPGA chip are connected to form a preliminary sample IC device. Evaluation test (preliminary evaluation) of the preliminary sample IC device is performed, and the final logic design data is obtained on the basis of the result of the test and used to form a wiring conductor pattern on the semi-completed sample IC chip to make an IC device.

Alternately, instead of the formation of wiring conductors connected to the function block as the external device which the user newly develops, a logic programmable gate array may be provided beforehand at a position in a layout on the substrate where the function block which the user newly develops is to be disposed.

According to the above technique, the maker is allowed to perform steps of fabricating a target semiconductor integrated circuit chip (up to the formation of doped layers, for example, diffusion layers, or upto a step right before wiring conductor pattern formation step) until the maker receives from the user logic design data of the function block which the user newly develops. After the maker has received the logic design data from the user, the maker is able to design a wiring conductor pattern of that function block to perform the remaining wiring conductor pattern forming step immediately to make an evaluation LSI device. Thus, the object of the present invention to reduce the turnaround time of a large-scaled ASIC will be achieved.

In the drawings:

Fig. 1 shows an illustrative block structure of an ASIC fabricated in one embodiment of the present invention.

Fig. 2 shows an illustrative block structure of a preliminary sample IC device for preliminary evaluation in another embodiment of the present invention.

Fig. 3 is a cross-sectional view of a combination of a semi-completed sample IC chip and a FPGA chip which constitute a preliminary sample IC device of Fig. 2.

Fig. 4 is a block diagram showing a further illustrative structure of an evaluation IC device in one embodiment of the present invention.

Fig. 5 is a flowchart showing a process of fabricating an IC device in one embodiment of the present invention in connection with design on the part of a user and design on the part of a maker.

Fig. 6 is a flowchart showing another process of fabricating an IC device in one embodiment of the present invention in connection with design on the part of a user and design on the part of a maker.

### (Embodiment 1)

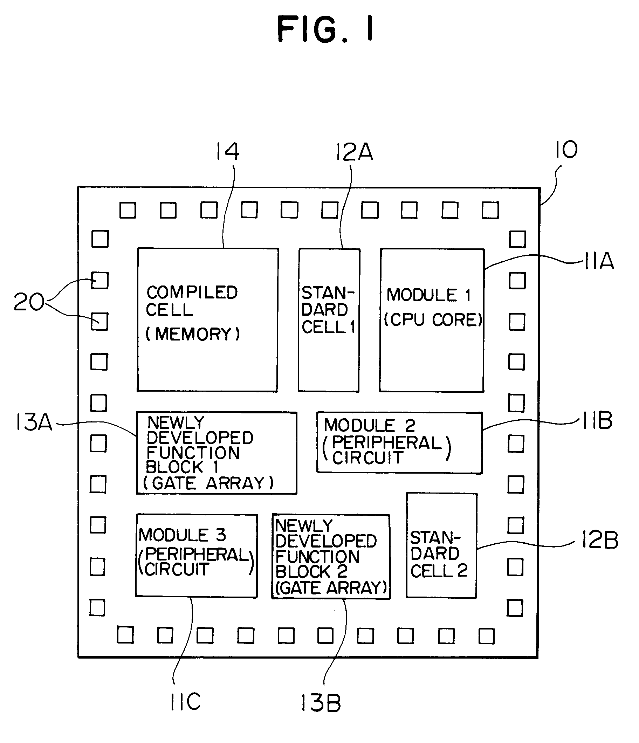

Fig. 1 shows a preferred block structure of an ASIC device to which a process of designing an LSI device according to the present invention is applied. In Fig. 1, the LSI device is provided with function blocks 11A, 11B, 11C, 12A, 12B, 13A, 13B and 14 formed on or in a semiconductor substrate 10 made of, for example, a single crystal silicon. The function blocks 11A, and 11B, 11C constitute a standardized CPU core and peripheral circuits (generally called a function module), respectively, which the maker has designed in the past and logic design data of which the maker has possessed. The function blocks 12A, 12B constitute circuits (also called a standard cell) which the user has already developed and logic design data of which the user has possessed. Each of the function blocks 13A and 13B includes a gate array which the user has newly developed. The function block 14 is another function block which includes, for example, a memory or an operation unit. Design data on a memory having a desired capacity which constitutes the function block 14 or design data on an operation unit which has a desired number of bits is produced easily by a module compiler which the maker provides. It is to be noted that the memory or the computing unit may be provided as a module or a standard cell. Reference numeral 20 denotes bonding pads as external terminals formed along the periphery of the semiconductor substrate 10.

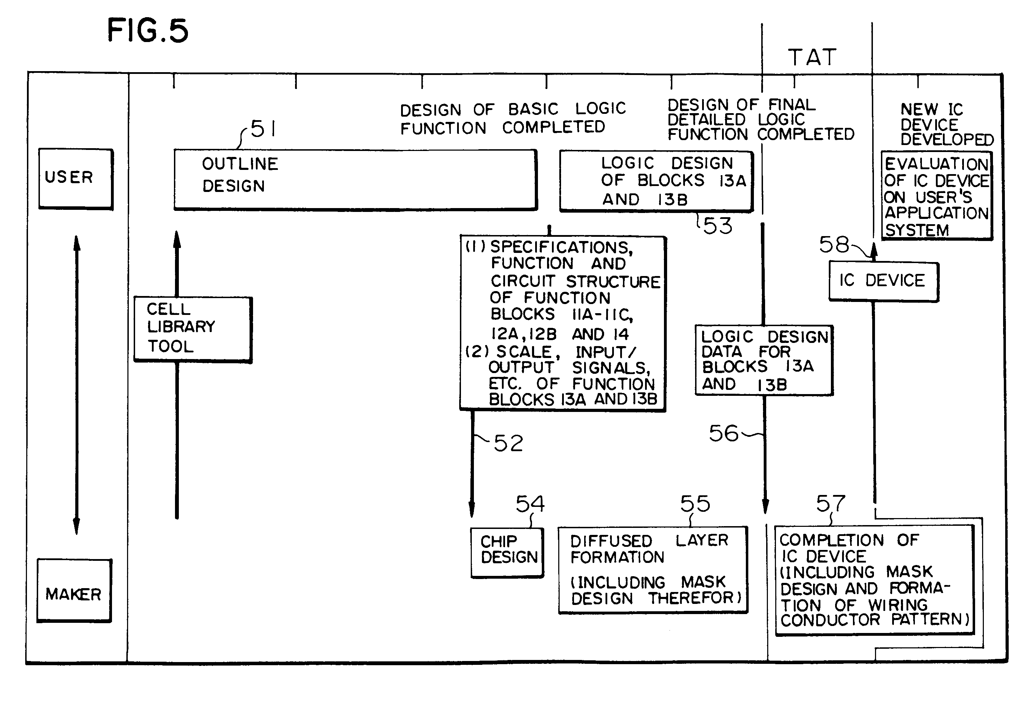

A process of designing an LSI having the above structure will be described with reference to Fig. 5. First, a user determines function blocks 11A-11C, 12A, 12B, 13A, 13B, and 14 as being necessary for realizing a LSI device having a desired logic function, for example, using a cell library tool which the maker provides, and performs outline logic design (for example, input/ output signals, functions and scale) of a whole LSI device including a combination of those function blocks (51). At this stage, the user delivers to a maker data on the specifications, functions and circuit structure of the function blocks 11A-11C, 12A, 12B and 14 whose data on the logic design is available, that is, data on the kind of those modules, logic design data on the standard cell, data on the structure of a compiled cell, and data on the input/output signals and the scale of (e.g., number of gates or transistors to be used in) the function blocks 13A, 13B which the user is intended to newly develop and whose logic design data is not available (52). Data on the standard cell which the user has already developed and logic design data on which the user possesses preferably contains data on the pattern of doped layers, for example, diffusion layers for circuit elements and data on a wiring conductor pattern. After the user has delivered those data items to the maker, the user immediately starts logic design on the function blocks 13A and 13B (53).

The maker performs chip design including determination of the layout of the function blocks on the basis of the data which the maker has received and data on the module or cell which the maker possesses (54). The maker designs and makes masks which are necessary for formation of doped layers, for example diffusion layers, of circuit elements which constitute the function blocks 11A-11C, 12A, 12B and 14 whose design data is available, and which are necessary for the formation of diffusion layers of elements which constitute gate arrays including basic logical gates corresponding in number to the scale of the function blocks 13A, 13B. The maker uses those masks to make plural semi-completed semiconductor chips with the diffusion layers formed thereon (prior to the formation of the wiring conductors) (55). The maker further completes design of wiring conductor pattern among the function blocks and waits for further information from the user.

When the maker receives from the user formerly unavailable logic design data for the function blocks 13A, 13B (56), the maker designs contact holes, through holes, wiring conductor patterns on the basis of those data items. The maker then uses the design data, the wiring conductor pattern data for the function blocks (standard cells) 12A, 12B which the maker has already received, and the wiring conductor pattern data for the function blocks 11A-11C (modules) which the maker possesses to make an evaluation sample LSI device where conductors are formed on the chip (57) and provides an evaluation LSI device for the user (58). The user then incorporates the evaluation LSI device provided by the maker into a user application system to evaluate a developed LSI device (59).

As a result of the evaluation, when the user finds a bug, the user will be able to modify the logic design, and delivers the corrected data to the maker. The maker then corrects the wiring conductor pattern, makes a new evaluation LSI device on the basis of the corrected pattern and delivers the LSI device to the user, who then performs re-evaluation. In that correction, the maker uses chips where fabrication steps up to formation of diffusion layers illustrated at step 55 has already been performed.

According to design process of this embodiment, the maker starts to make a target semiconductor integrated circuit chip while the user is performing logic design of the function blocks 13A, 13B whose logic design data is unavailable. After the maker has received the logic design data on the function blocks 13A, 13B from the user, the maker is able to design a wiring conductor pattern for the function blocks and to complete an evaluation LSI device by immediately performing the remaining wiring conductor forming process. Therefore, 60-70% of the process beforehand precedes the conventional process where after the user completed final logic design, the maker delivers the data to the maker to start design and manufacture of the chip. As a result, the turn-around time of the LSI device is reduced by 1.5-2 months.

Further, according to the designing process of the embodiment, any function is selected by changing the wiring conductor pattern at step 57 from among function circuits incorporated beforehand into the newly developed function blocks 13A and 13B. Thus, by realizing different logic functions in the function blocks 13A and 13B without repeating steps 51-56, it is advantageously possible in a shotened turn-around time to develop different IC devices capable of different operations though same function circuits are used in combination in the different IC devices.

### (Embodiment 2)

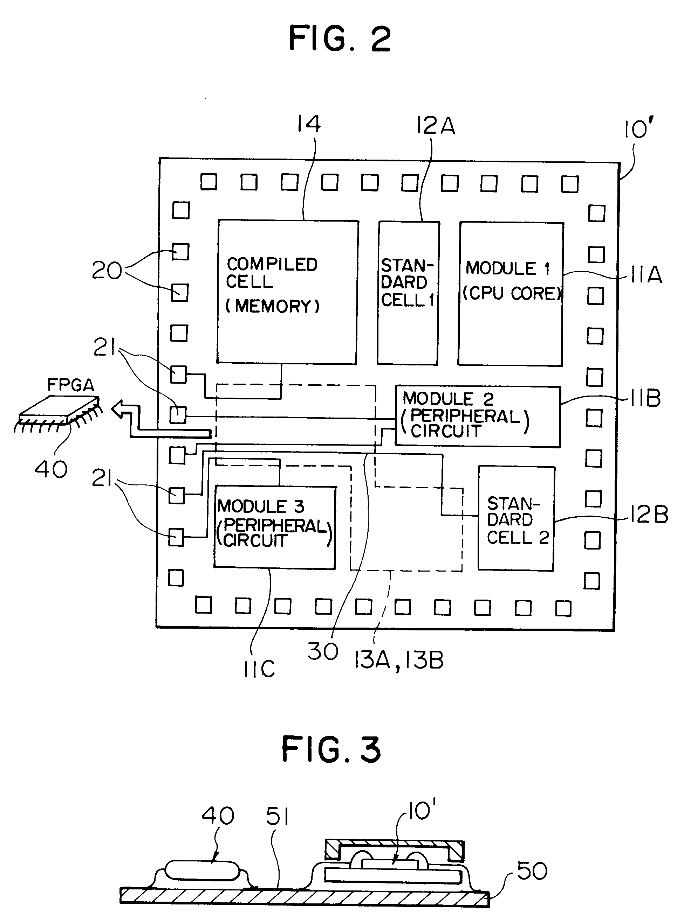

Fig. 2 shows another preferred embodiment of an ASIC block structure to which the LSI device designing process according to the present invention is applied. The evaluation LSI device of this embodiment includes function blocks substantially similar to the LSI device of Fig. 1 except that a preliminary evaluation LSI device is made before the formation of the evaluation LSI device. In the embodiment of Fig. 1, the function blocks 13A, 13B which the user intends to newly develop are formed along with other function blocks 11A-11C, 12A, 12B and 14 by gate arrays in the same semiconductor chip 10, while in the second embodiment the function blocks 13A, 13B which the user intends to newly develop are formed outside the chip 10' to make a preliminary evaluation LSI device, with connection terminals 21 and conductors 30 for connecting the terminals 21 and other function blocks 11A-11C, 12A, 12B and 14 being formed on the chip 10'. The place on the completed evaluated chip where the newly developed function blocks 13A, 13B are to be formed will be a blank area (shown by broken lines) where no elements are formed or an area where the gate array elements (covered with an insulating film and not connected electrically) are formed.

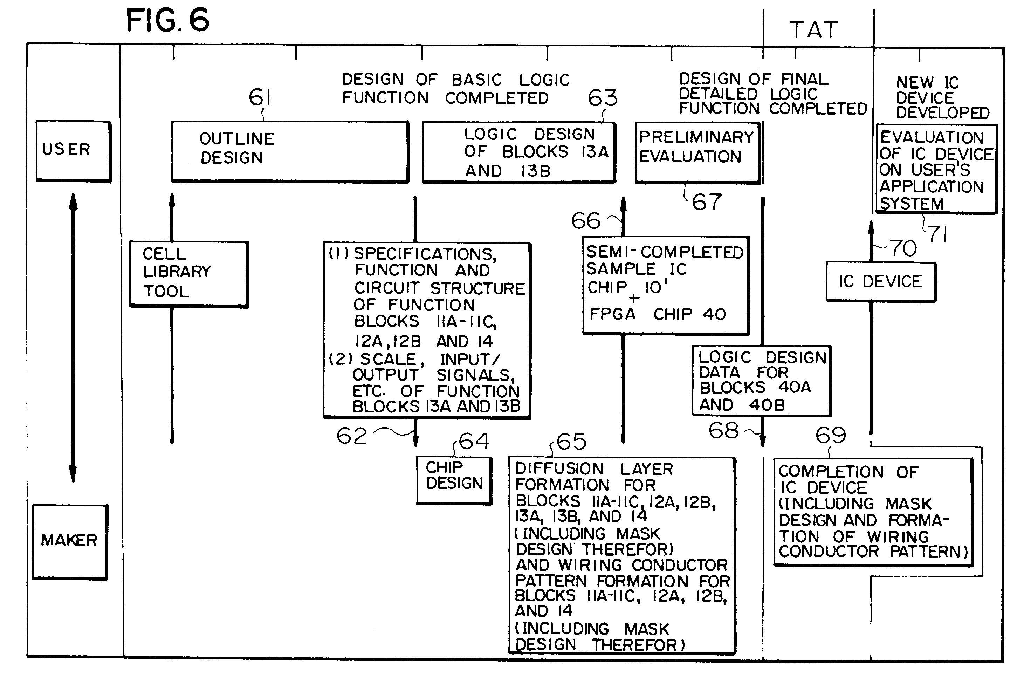

For fabrication of the evaluation LSI device of this embodiment, assume that the user has selected the function blocks 11A-11C, 12A, 12B and 14 as ones necessary for realizing an LSI device having a desired logic function, as shown in Fig. 6. The user performs outline logic design of a whole LSI device having combined functions of those function blocks (61). The user delivers to the maker data on the specifications, functions, circuits of the function blocks 11A-11C, 12A, 12B and 14 whose logic design data is available, data on the scale of the functional 13A, 13B which the user intends to newly develop and the related input and output signals (62). Thereafter, the user immediately starts logic design of the function blocks 13A, 13B (63). The maker determines the layout of the function blocks and performs chip design on the basis of the data which the maker has received and data on the modules and cells which the maker possesses (64). The maker designs and makes masks necessary for the formation of the diffusion layers and wiring conductor pattern for circuit elements which constitute the function blocks 11A-11C, 12A, 12B and 14 whose design data is available, and necessary for the formation of diffusion layers for elements which constitute gate arrays including basic logic gates corresponding in number to the scale of the function blocks 13A, 13B. The maker then uses those masks to make plural semi-completed semiconductor IC chip 10' where the diffusion layers and wiring conductor pattern for the function blocks 11A-11C, 12A, 12B and 14 are formed and a plurality of field programmable gate array (FPGA) chips 40 to program the logical functions of the function blocks 13A, 13B (65). The maker supplies to the user the manufactured semiconductor chips 10' and FPGA chips 40 (which constitute in combination an evaluation LSI device) (66). At this stage, the maker stocks plural chips where fabrication steps up to formation of diffusion layers has already been performed or plural chips 10' where no wiring conductors are formed, for the function blocks 13A, 13B.

When the logic design of the function blocks 13A, 13B is finished, the user programs the logic functions of the newly developed function blocks 13A, 13B into the FPGA chip 40 which the maker has supplied on the basis of the logic design data. The user then electrically connects the FPGA chip 40 and a semi-completed semiconductor IC 10', for example, as shown in Fig. 3, to constitute a preliminary sample IC device for preliminary evaluation, incorporates the preliminary sample IC device into a user application system and performs preliminary evaluation of the logic of the semi-completed IC chip 10' and EPGA chip 40 (67).

In the connection for the preliminary evaluation of Fig. 3, the semi-completed chip 10' and the EPGA chip 40 are incorporated into corresponding separate packages, which are then attached to a single printed board 50 and connected by printed wiring conductors 51. Alternately, the semi-completed chip 10' and the FPGA chip 40 may be incorporated in the same package and connected to each other by bonding wires or the like to make a preliminary sample IC device for preliminary evaluation.

When the user finds a bug as the result of the preliminary evaluation, the user corrects the logic functions, rewrites or replaces data in the EPGA chip 40 on the basis of data for correction and again evaluates and determines the final logic of the function blocks 13A, 13B. The user then delivers the final logic design data to the maker (68). The maker designs a mask for the wiring conductor pattern and forms the wiring conductor pattern (69), makes an evaluation LSI device where the newly developed function block 13 is provided in the area shown by broken lines on the chip 10 of Fig. 2, and supplies the obtained LSI device to the user (70). The user then performs a final evaluation (71).

According to the preliminary evaluation LSI device of this embodiment, the maker supplies to the user the newly developed function blocks 13A, 13B as the FPGA chip 40 other than the semi-completed chip 10' where function blocks 13A, 13B are formed whose logic design data is available. Thus, the user is able to correct the logic very easily in a short time. Therefore, the turn-around time is reduced advantageously compared to the process of the embodiment 1 where each time the logic is corrected in a newly developed function blocks 13A, 13B, the user requests the maker to change the wiring conductor pattern and to make an evaluation LSI device (step 57 of Fig. 5). Thus, the present embodiment is especially effective if used when the logic design of the function blocks 13A, 13B to be newly developed may be changed or corrected.

### (Embodiment 3)

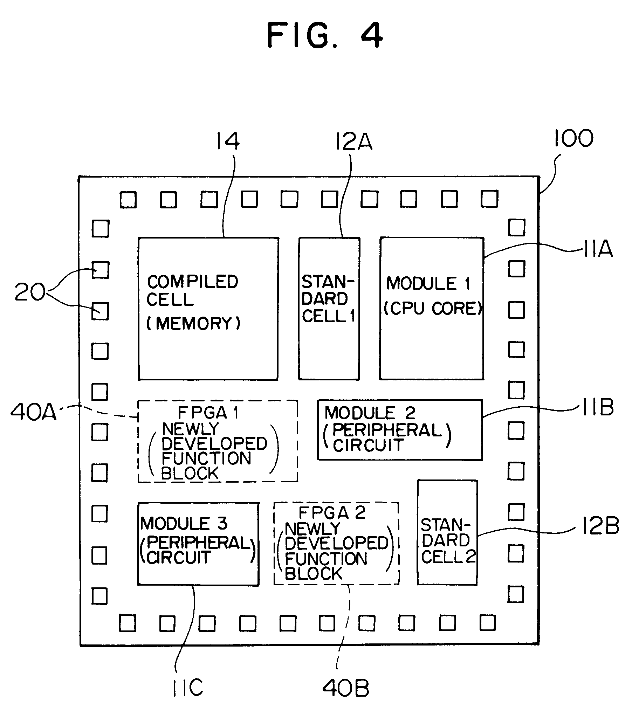

Fig. 4 shows a further preferred embodiment of the ASIC block structure to which the LSI designing process according to the present invention is applied. While in the evaluation sample LSI device of Embodiment 3, newly developed function blocks 13A, 13B are formed in the FPGA chip 40 which is separate from the chip 10' in which the function blocks 11A-11C, 12A, 12B and 14 are formed for the purpose of the preliminary evaluation, the blocks 13A, 13B in this embodiment are formed as FPGA function blocks 40A, 40B incorporated into one and the same semiconductor chip 100 for preliminary evaluation. The evaluation LSI device of this embodiment is easy for the user to correct its logic function like that of the embodiment 2 because the LSI device includes the FPGA function blocks, and is easy to handle compared to the embodiment 2, owing to no connections required between the chips.

As described above, in the above embodiments, when a semiconductor integrated circuit is designed which includes a combination of at least a standardized function block which the maker has developed and possessed, a function block which the user has already developed and possessed, or both those function blocks, and a function block which the user has newly developed, a semi-completed IC chip is prepared by use of logic design data of the standardized function block and/or logic design data of the function block which the user possesses, the semi-completed IC chip having a semiconductor substrate including therein diffusion or doped layers for elements and a gate array necessary for realization of the functions of the function blocks. A wiring conductor pattern for the function blocks including the gate array which the user has newly developed is designed on the basis of the logic design data on that function block. The wiring conductor pattern data, the logic design data on the function block which the maker possesses and the logic design data of the function blocks which the user possesses are used to determine a wiring conductor pattern of the whole prepared semi-completed sample IC chip. Thus, the maker is able to make a target semiconductor integrated circuit chip (fabrication steps up to formation of a doped layer, for example, a diffusion layer) before the maker receives from the user logic design data on the function block which the user newly develops. After the maker has received the logic design data from the user, he is able to design a wiring conductor pattern of that function block and to perform immediately the remaining wiring conductor pattern forming step to thereby make an evaluation LSI device. Thus, the turn-around time of a large-scaled ASIC device is reduced, advantageously.

In addition, when the respective function blocks are mounted on a semiconductor chip, with a testing circuit additionally provided to each of their respective signal input/output portions so that data may be read from/written into terminals of the package to thereby facilitate testing and reduce the testing time of the LSI device and hence the turn-around time of the ASIC.

While the present invention has been described with respect to its specific embodiments, it is not limited to those embodiments. Various changes and modifications are possible by those skilled in the art without departing from the spirit and scope of the invention, of course. For example, while in the above embodiments description has been made of design of a semiconductor integrated circuit having a combination of a standardized function block which the maker possesses, a function block which the user has already developed and possessed, a function block including a gate array which the user has newly developed, and other function blocks, the present invention is not limited to those particular cases. The present invention is applicable to design of a semiconductor integrated circuit having of a combination of a standardized function block which the maker possesses, and a function block including a gate array which the user has newly developed as well as to design of a semiconductor integrated circuit having of a combination of a function block which the user has already developed and possessed and a function block including a gate array which the user has newly developed.

While in the above application of the present invention to the development of a control LSI such as a single chip microcomputer having a CPU core in a field of utilization as the background of the invention has been illustrated, the present invention is not limited to that case and is generally applicable to the development of an LSI device having a new function using a circuit which is already used and has brought about useful results.

## Claims

1. A process of fabricating an IC device to be newly developed having at least one first function block (11A-11C, 12A, 12B, 14) and at least one second function block (13A, 13B), said first and second function blocks of said to-be-newly developed IC device being formed in a single semiconductor substrate, wherein logic design data of said first function block is available and that of said second function block needs to be newly prepared at a start of fabrication of the IC device, the process comprising the steps of:
performing (53) logic design of said second function block (13A, 13B) to prepare logic design data of said second function block while doped layers are formed in a semiconductor substrate (10) for said first and second function blocks to provide (54, 55) a semi-completed IC chip;
upon completion (56) of preparation of said logic design data of said second function block, performing (57) mask design of wiring conductor pattern using said logic design data of said first function block and said logic design data of said second function block to prepare mask design data for said IC device; and
forming (57) wiring conductor pattern using said mask design data on said semi-completed IC chip to complete a newly developed IC device.

2. A process according to claim 1, wherein said first function block includes circuits of a standard cell system and said second function block includes circuits of a gate array system.

3. A process according to claim 1, wherein said second function block is provided in a field programmable gate array (40A, 40B).

4. A process of fabricating an IC device to be newly developed having at least one first function block (11A-11C, 12A, 12B, 14) and at least one second function block (13A, 13B), said first and second function blocks of said to-be-newly developed IC device being formed in a single semiconductor substrate, wherein logic design data of said first function block is available and that of said second function block needs to be newly prepared at a start of fabrication of the IC device, the process comprising the steps of:
performing (63) logic design of said second function block (13A, 13B) to prepare logic design data of said second function block while doped layers and wiring conductors are formed in a semiconductor substrate (10') for said first function block (11A-11C, 12A, 12B, 14) to provide (65) a semi-completed sample IC chip and doped layers are formed in another semiconductor substrate for said second function to provide (65) a field programmable gate array chip (40);
upon completion of preparation of said logic design data of said second function block, programming said field programmable gate array chip using said logic design data of said second function block;
connecting said semi-completed sample IC chip with said rogrammed field programmable gate array chip to complete a preliminary sample IC device and preliminarily evaluating (67) said preliminary sample IC device;
performing (69), after said preliminarily evaluating step, mask design of wiring conductor pattern using said logic design data of said first function block and said said logic design data of said second function block to prepare mask design data for said IC device; and
forming (69) wiring conductor pattern using said mask design data on said semi-completed sample IC chip to complete a newly developed IC device.

5. A process according to claim 4, wherein said semi-completed sample IC chip and said programmed field programmable gate array chip are mounted with a single package to provide said preliminary sample IC device for said preliminary evaluation.

6. A process according to claim 4, wherein said semi-completed sample IC chip and said programmed field programmable gate array chip are mounted with different packages to provide said preliminary sample IC device for said preliminary evaluation.

7. A process of fabricating an IC device to be newly developed having at least one first function block (11A-11C, 12A, 12B, 14) and at least one second function block (13A, 13B), said first and second function blocks of said to-be-newly developed IC device being formed in a single semiconductor substrate, wherein logic design data of said first function block is available and that of said second function block needs to be newly prepared at a start of fabrication of the IC device, the process comprising the steps of:
performing (63) logic design of said second function block (13A, 13B) to prepare logic design data of said second function block while doped layers and wiring conductors for said first function block (11A-11C, 12A, 12B, 14) and doped layers for said second function are formed in a semiconductor substrate to provide (65) a semi-completed IC chip, said doped layers for said second function block being in a field programmable gate array;
upon completion of preparation of said logic design data of said second function block, programming said field programmable gate array using said logic design data of said second function block to complete a preliminary IC device;
preliminarily evaluating (67) said preliminary IC device;
performing (69), after said preliminarily evaluating step, mask design of wiring conductor pattern using said logic design data of said first function block and said logic design data of said second function block to prepare mask design data for said IC device;
and
forming (69) wiring conductor pattern using said mask design data on said semi-completed IC chip to complete a newly developed IC device.

8. An IC device having at least one first function block and at least one second function block formed in a single semiconductor substrate, wherein said first function block includes circuits of a standard cell system, and said second function block includes circuits programmed in a field programmable gate array.
